Europäisches Patentamt

(19) European Patent Office

Office européen des brevets

(11) EP 0 718 963 A1

(12) EUROPEAN PATENT APPLICATION

(43) Date of publication:
26.06.1996 Bulletin 1996/26

(51) Int. Cl.$^6$: H03C 3/09

(21) Application number: 95308837.4

(22) Date of filing: 06.12.1995

(84) Designated Contracting States:
DE GB

(30) Priority: 22.12.1994 US 362397

(71) Applicant: AT&T Corp.
New York, NY 10013-2412 (US)

(72) Inventors:
• Greaney, Shaun Joseph
Tinton Falls, New Jersey 07724 (US)
• Orlando, Denis P.
Freehold, New Jersey 07728 (US)

• Kasturia, Sanjay
Middletown, New Jersey 07748 (US)
• Prise, Michael Edward
Atlantic Highlands, New Jersey 07716 (US)

(74) Representative: Buckley, Christopher Simon
Thirsk et al
AT&T (UK) LTD.,
AT&T Intellectual Property Division,
5 Mornington Road
Woodford Green, Essex IG8 0TU (GB)

(54) Method and apparatus for broadband frequency modulation of a phase-locked frequency synthesizer

(57) A divider (20) and a phase detector (12) combination which is included in a phase-locked loop utilized for providing broadband frequency modulation (on 54) contributes a spurious delay to the feedback path of the loop that causes distortions in the frequency modulation response. The introduction of a compensating delay to the feedback signal path of the phase-locked loop by the inclusion of a delay element (70) in a modulating signal input path (60,16,14) provides for minimization of the distortions in the frequency modulation response.

FIG. 3A

## Description

### Field of the Invention

This invention relates generally to frequency modulation of a phase-locked oscillator: More particularly, the present invention concerns a technique for reducing distortion in the modulation response of a broadband phase-locked frequency synthesizer.

### Background

A phase-locked loop (PLL) which includes a voltage controlled oscillator (VCO) is typically utilized for synthesizing a stable or phase-locked frequency signal In various applications, the VCO in a PLL may be frequency modulated according to well known techniques to provide for a modulated phase-locked output signal For instance, the injection of a modulating voice signal into a PLL transforms the PLL into a voice information transmission source called a modulated phase-locked frequency synthesizer or source.

A PLL which includes a frequency divider in its architecture may be operated as a broadband phase-locked frequency source. Frequency modulation of a broadband phase-locked source is performed in systems, such as advanced wireless digital communication systems. One example of such a system is a frequency hopped cordless telephone system, which utilizes a plurality of frequency channels for transmitting information during a single communication.

A current design architecture of a broadband PLL which is used for communication purposes is described in L. Nguyen, "Wideband Phase-Locked Angular Modulator," Jet Propulsion Lab. Telecommunications and Data Acquisition Progress Report, N90-12798, August 1989, pp. 150-56, and incorporated by reference herein It has been experimentally determined, however, that a PLL having the architecture described in Nguyen does not produce a flat modulation response over frequencies that span the loop bandwidth. Distortions in the frequency response at these frequencies cause unacceptable distortions in the quality of voice signals or in the error rates of digital signals transmitted in a frequency hopped system

### Summary of the Invention

The present invention concerns a technique for minimizing any frequency dependent distortions in the frequency modulation response of a broadband phase-locked loop (PLL) frequency synthesizer which may be caused by the interaction of the feedback loop with a modulating signal.

One current design architecture of a broadband PLL comprises a voltage controlled oscillator (VCO), a divider, a loop filter, an integrating block, a phase detector, a first and second summing block and a first and second modulating signal path leading from a modulating source, the first modulating signal path leading to the input of the loop filter and the second modulating signal path leading to the output of the loop filter, In accordance with this invention, the PLL is modified by the introduction of a calculated amount of compensating delay into the first modulating signal path. The compensating delay is included in the first modulating signal path to compensate for a spurious phase shift or delay, which is introduced to the feedback path of the PLL by the divider and which distorts the modulation response of the PLL The amount of compensating delay which is introduced to the first modulating signal path of the PLL determines the extent that the distortion in the modulation frequency response is minimized at particular frequencies.

In one embodiment, the compensating delay may be introduced by including a low pass filter in the first modulating signal path. The order of the low pass filter determines the amount of delay introduced into the path at a particular frequency

In a further embodiment, the compensating delay may be introduced in the form of a digitally implemented delay line element which is included in the first modulating signal path.

The many advantages of the present invention will be readily apparent from the detailed description and the drawings that follow.

### Description of the Drawings

FIG. 1 illustrates a block diagram of a prior art broadband phase-locked loop frequency synthesizer.

FIG. 2 shows a plot of the frequency modulation response of an empirical implementation of the phase-locked loop in FIG. 1.

FIG. 3A illustrates the addition of a delay element to a modulating signal input path of the phase-locked loop in FIG. 1 according to the present invention

FIG. 3B illustrates a single pole low pass filter embodiment of a delay element which may suitably be included in the modulating signal path of the phase-locked loop in FIG. 3A.

FIGS. 4A and 4B show plots of the magnitude and phase, respectively, of the calculated frequency modulation response of the phase-locked loop shown in FIG 1 without the addition of a compensating delay, and of the phase-locked loop shown in FIG. 3A with a compensating delay added according to the present invention.

FIG. 5 illustrates a digital implementation of a delay element which may suitably be included in the modulating signal path of the phase-locked loop in FIG. 3A.

## Detailed Description

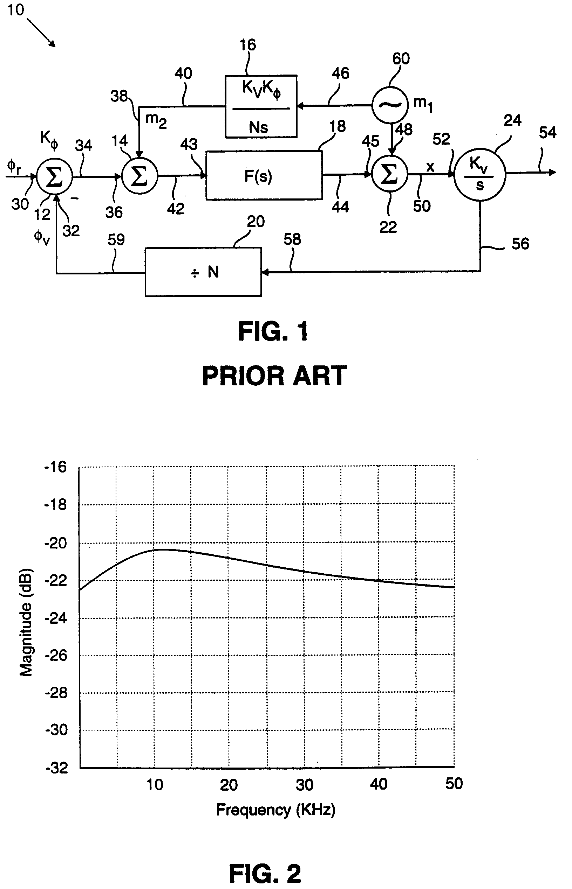

FIG. 1 shows a generalized block diagram of a prior art phase-locked loop (PLL) 10 which is typical of the architecture utilized in a broadband frequency modulated phase-locked frequency synthesizer. The architecture and the manner of operation of the PLL 10 is first described in detail below to provide a background for an understanding of the present inventive technique of introducing a compensating delay into a modulating input signal path of the PLL 10 to minimize distortions in the frequency modulation (FM) response. Then, a detailed description of the inventive technique for introducing a compensating delay to the PLL 10 and calculating the optimal amount of compensating delay to be added is provided.

Referring to FIG. 1, the PLL 10 comprises a phase detector 12, a first summing block 14, an integrator block 16, a loop filter 18, a divider 20, a second summing block 22, a voltage controlled oscillator (VCO) 24 and a modulating signal source 60 It is to be understood that the PLL 10 may include additional components for receiving and processing an injected modulation signal such as a voice signal

The phase detector 12 comprises a reference input 30, a variable frequency input 32 and a phase error voltage signal output 34. The summing block 14 includes a first input 36 which is connected to the output 34 of the phase detector 12, and a second input 38 which is connected to an output 40 of the integrator block 16 The summing block 14 further comprises an output 42 which is connected to an input 43 of the loop filter 18. The integrator block 16 further comprises an input 46.

The loop filter 18 further comprises an output 44 which is connected to an input 45 of the summing block 22. The summing block 22 further includes an input 48, and an output 50 which is connected to a tuning input 52 of the VCO 24. The VCO 24 further comprises a first output 54, and a second output 56 which is connected to an input 58 of the divider 20. The divider 20 also includes an output 59 which is connected to the input 32 of the phase detector 12.

The modulating signal source 60 is connected to the input 46 of the integrator block 16 and the input 48 of the summing block 22. As explained below the modulating source 60 provides the modulating signals which may be injected into the PLL 10 for producing a modulated output signal at the VCO 24. A reference signal is provided at the input 30 of the phase detector 12 from a source, not shown.

For ease of reference, the following notation is used to explain the present invention with reference to the PLL 10. The gain of the phase detector 12 is expressed as $K_\phi$; the gain of the VCO 24 is expressed as $K_v/s$, where $s$ is equal to $j\omega$; the transfer function of the loop filter 18 is expressed as $F(s)$ and is suitably equal to $(1+\tau_2 s)/(1+\tau_1 s)$; the transfer function of the integrator block 16 is expressed as $K_v K_\phi/Ns$; and, the gain of the divider 20 is expressed as $1/N$, where $N$ is equal to the number of leading edges that the divider 20 must detect at the input 58 before providing an output edge at the output 59. As explained below, the operation of the divider 20 may cause distortions in the FM response of the PLL 10 which may be compensated for according to the present inventive technique where Further, the phase of a reference frequency signal applied at the input 30 of the phase detector 12 is referred to as $\phi_r$ and the phase of a frequency signal applied at the input 32 of the phase detector 12 is referred to as $\phi_v$. A modulating signal applied by the source 60 to the PLL 10 at the input 48 of the summing block 22, in other words the modulating signal provided by the source 60, is defined as $m_1$. The modulating signal applied at the input 38 of the summing block 14 is defined as $m_2$. The modulating signal path leading to the input 38 of the summing block 14 is referred to as the first modulating signal path, and the modulating signal path leading to the input 48 of the summing block 22 is referred to as the second modulating signal path. In addition, the tuning signal in the tuning signal path leading from the output 50 of the summing block 22 to the input 52 of VCO 24 is defined as $x$.

The components of the PLL 10 are standard components which, according to the basic principles of phase-locked loop operation, may be utilized for providing an output signal at the output 54 of the VCO 24 which may be frequency modulated according to modulating signals injected by the source 60.

The theoretical FM response of the PLL 10 may be determined by performing a linearized small-signal analysis on the PLL 10. *See Nguyen*, cited above. The following equations describe the operation of the PLL 10:

$$N\phi_v = -\phi_v K_\phi F(s)\frac{K_v}{s} + m_2 F(s)\frac{K_v}{s} + m_1 \frac{K_v}{s} \tag{1}$$

$$\phi_v = (m_1\frac{K_v}{s} + m_2 F(s)\frac{K_v}{s})\frac{1}{N+K_v K_\phi F(s)/s} \tag{2}$$

As described above, the tuning signal $x$ represents the effect, at the input 52 of the VCO 24, of the modulating signal supplied to the PLL 10 by the source 60, and may be expressed as:

$$x = m_1 + m_2 F(s) - \phi_v K_\phi F(s), \tag{3}$$

$$m_2 = K_v K_\phi \frac{m_1}{Ns}. \tag{4}$$

By substituting for $m_2$ and $\phi_v$ in equation 3 using equation 4 and equation 2, respectively, it can be shown that equation 3 reduces to $x$ $m_1$. In other words, the theoretical signal analysis of the PLL 10 indicates a flat frequency response for any modulating signal which is supplied to the PLL 10 from the source 60 because $m_1$ is equal to the function of the modulating signal supplied by the source 60.

In practice, the phase detector 12, the summing blocks 14 and 22, the divider 20, the loop filter 18, the modulating source 60 and the VCO 24 in the PLL 10 are typically implemented using conventional discrete components. In addition, the integrator block 16 is typically implemented as an operational amplifier based integrator.

FIG. 2 shows a plot of the FM response of the PLL 10 as measured at the output 54 of the VCO 24 using an FM demodulator and a dynamic signal analyzer, where the components of the PLL 10 are implemented as described above. In FIG 2, the frequency at which modulating signals are applied to the PLL 10 by the source 60 is indicated in kilohertz (KHz) on the x-axis, and the relative FM index of the signal which is supplied by the VCO 24 due to the modulation applied by the source 60 is plotted in dB along the y-axis.

Referring to FIG. 2, it is seen that the measured FM response of the PLL 10 is not a flat frequency response, as would be expected based on the small-signal analysis of the PLL 10 set forth above but, instead, includes distortions. As is well known, distortions in the frequency response of the PLL 10 may occur if the amplitude of the tuning signal $x$ which is supplied on the path to the input 52 of the VCO 24 varies relative to the amplitude of the modulating signal $m_1$ as the frequency that the modulating signal provided by the source 60 is varied.

Referring again to FIG. 2, the plot of the measured FM response shows that approximately 2 dB of distortion occurs at various frequencies. It is well known that this level of frequency distortion may render the modulation structure of a phase-locked loop having an architecture similar to the PLL 10 unusable in some non-frequency hopped and frequency hopped systems, such as, for example, a digital wireless system using multi-level, low deviation continuous phase frequency shift key (CPFSK) modulation.

Referring to FIG. 1, the variations in the amplitude of $x$ relative to amplitude of $m_1$ may be caused when the transfer functions of the first and second modulating signal paths, for the modulating signal provided by the source 60, do not continuously vectorially sum at the output 50 of the second summing block 22 to a frequency independent transfer function. For a constant amplitude sinusoid supplied by the source 60, variations in the amplitude of $x$ relative to the amplitude of $m_1$, as the frequency of the source 60 is varied, cause the frequency deviation of the output of the VCO 24 to vary accordingly. For example, if the PLL 10 is configured to provide a 1 GHz output signal at the output 54 without the application of a modulating signal, and if a modulating signal of frequency 5 KHz is injected into the PLL 10 by the source 60 with a level adjusted to modulate the VCO 24 with a frequency deviation of 100 KHz about 1 GHz, distortion in the FM response may cause the VCO 24 to provide output signals whose frequency deviation departs from 100 KHz as the modulating frequency is varied from 5 KHz.

The variation in the frequency deviation of the output of the VCO 24 from expected values is caused by the divider 20, which introduces a spurious phase shift or delay into the signal path leading to the input 32 of the phase detector 12. The changes in the frequencies of the signals supplied by the VCO 24 at the output 56 cause a delayed change in the frequency at the output of the divider 20. The delay arises because the divider 20 must count the preset number of $N$ leading edges before providing an output leading edge at the output 59. The approximation used for modeling this effect in our analysis, which is a continuous time analysis, is a time delay attributed to the divider 20 that is equal to one half the period to the reference frequency, and is described in detail in Egan, William, "Sampling Delay - Is It Real," RF Design (Feb. 1991), *reprinted in* Breed, G.A., ed., Frequency Synthesis Handbook (1992) pp. 28-30, incorporated by reference herein. For purposes of this description, the delay between the time that the frequency changes at the input 58 to the divider 20 and the time when the frequency of the signal at the output 59 changes in an expected manner is defined as $\tau$.

According to the principles of phase-locked loop operation, the introduction of a delay $\tau$ into the PLL 10 signal path in the input 32 of the phase detector 12 will affect the transfer function from the input 38 of the summing block 14 to the output 50 of the summing block 22. The phase delay introduced in the PLL 10 by the divider 20, essentially, causes a frequency dependent phase shift in the transfer function of the first modulation signal path through the integrator block 16.

According to the present invention, the distortions in the FM response of the PLL 10 may be reduced by the introduction of a compensating delay into the feedback signal path of the PLL 10 which compensates for the delay $\tau$. The compensating delay is suitably injected into the PLL 10 by including a delay element 70 in the first modulation signal path, in other words, in the path leading from the source 60 to the input 38 of the summing block 14.

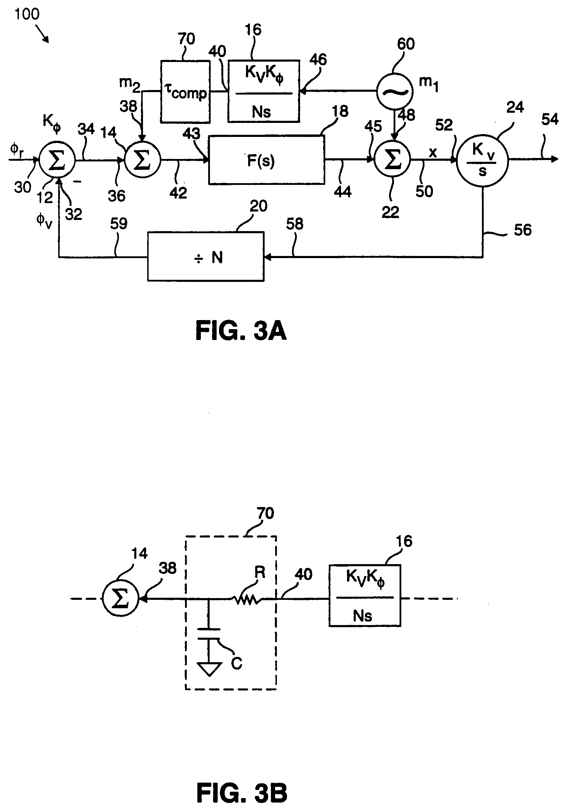

FIG. 3A shows a PLL 100, which is a modified version of the prior art PLL 10. Those components in the PLL 100 which are similar, and preferably identical, to the components in the PLL 10 are referred to below using the same reference numerals utilized in FIG. 1. Similarly, signal flow in the PLL 100 is described below using the same reference symbols used to describe signal flow in the PLL 10.

The PLL 100, as compared to the PLL 10, additionally includes the delay element 70 inserted in the first modulation signal path between the summing block 14 and the integrator block 16. It is to be understood that the inclusion of the delay element 70 between the summing block 14 and the integrator block 16 is exemplary, and that the delay element 70 may be added in any suitable manner which operates to add delay in the modulating signal path leading from the source 60 to the input 38 of the summing block 14.

The amount of compensating delay which may be added to the first modulation path of the PLL 100 for compensating for any delay $\tau$ which may be introduced by the divider 20 and the phase detector 12 combination may be determined as follows. For ease of description of the present invention, the delay $\tau$ is represented as a frequency dependent phase term in $K_\phi$, such that the gain of the phase detector 12 is defined as $K_\phi e^{-j\omega\tau}$. Therefore, referring to FIG. 1, the linearized small-signal analysis of the prior art PLL 10, which includes the effect of the delay $\tau$, may be accordingly expressed by modifying the equation I, such that:

$$N\phi_v = -\phi_v K_\phi e^{-j\omega\tau} F(s)\frac{K_v}{s} + m_2 F(s)\frac{K_v}{s} + m_1 \frac{K_v}{s} \tag{5}$$

and modifying equation 2, such that:

$$\phi_v = e^{j\omega\tau}\frac{(m_1 K_v + m_2 F(s) K_v)}{K_v K_\phi F(s) + Nse^{j\omega\tau}}. \tag{6}$$

Referring to FIG. 3A, a function $C(s)$ may be included in the expression for the modulating signal $m_2$ to represent the compensating delay which is introduced to the first modulating signal path of the PLL 100 by the inclusion of the delay element 70. The signal applied at the input 38 of the summing block 14, therefore, is expressed as

$$m_2 = K_v K_\phi C(s)\frac{m_1}{Ns}. \tag{7}$$

As explained below, $C(s)$ may be adjusted accordingly to compensate for the distortions which are caused by the delay $\tau$.

By substituting the expression for $m_2$ which includes the effect of the compensating delay $C(s)$, as shown in equation 7, into the equations 5 and 6 and solving for $x/m_1$ using the equation 3, it can be shown that

$$x/m_1 = \frac{s + C(s)F(s)\dfrac{K_v K_\phi}{N}}{s + F(s)\dfrac{K_v K_\phi}{N} e^{-j\omega\tau}} \tag{8}$$

Equation 8 may be rewritten in terms of a high pass response, $H_h(s)$, and a low pass response, $H_l(s)$, such that:

$$x/m_1 = (H_h(s) + H_l(s)) \tag{9}$$

where

$$H_h(s) = \frac{s}{s + F(s)\dfrac{K_v K_\phi}{N} e^{-j\omega\tau}} \tag{10}$$

and

$$H_l(s) = \frac{C(s)F(s)\dfrac{K_v K_\phi}{N}}{s + F(s)\dfrac{K_v K_\phi}{N}e^{-j\omega\tau}}, \tag{11}$$

in order to express the frequency response of the PLL 100 in terms of a high and a low frequency response transfer function, respectively.

The high pass response, $H_h(s)$, reduces to unity at high frequencies because it is known that the typical transfer function $F(s)$ of the loop filter 18 approaches zero at high frequencies. The low pass response, $H_l(s)$, which includes the contributing effect of the divider 20 delay $\tau$, has unity magnitude at low frequencies if the term $C(s)$ is ignored. As shown in the equation 11, $H_l(s)$, however, further includes the frequency dependent phase term, $e^{-j\omega\tau}$, in the denominator.

Referring to the equation 11 set forth above, if $C(s)$ is set equal $e^{-j\omega\tau}$, then the PLL 100 would have a perfectly flat modulation response. $H_l(s)$ would reduce to unity at low frequencies because the frequency dependent phase terms in the numerator and denominator would cancel. It is known, however, that setting $C(s)$ equal to $e^{-j\omega\tau}$ requires that the delay element 70 be implemented in the PLL 100 as a frequency independent delay. A frequency independent delay, in practice, is impractical to realize as an analog component in a broadband phase-locked source because it would require that a long wire having a propagation delay equal to $\tau$ be included in the first modulating path. The electrical length of a wire required to be included may be determined by multiplying the delay $\tau$ by the velocity of light. For example, if $\tau$ is equal to 10 $\mu$s, the electrical length of the wire would be equal to 3 km, Therefore, alternative techniques for implementing delay compensation in the PLL 100 according to the present invention are described below.

In one embodiment of the present invention, the delay element 70 may be implemented in the PLL 100 as a low pass filter. A low pass filter is a suitable component for providing a compensating delay because it has a transfer function that may approximate a delay in the portion of the frequency band where the transfer function $F(s)$ of the loop filter 18 is significant. Note, $F(s)$ is typically a low pass response, hence, the term $H_l(s)$, as shown in equation 11, will approach zero as $s$ increases at higher frequencies.

By way of example, the delay value for $C(s)$ may be approximated by implementing the delay element 70 as a first order or single pole low pass filter, as shown in FIG. 3B. The delay element 70, implemented as a conventional first order low pass filter, includes a resistor R connected in the signal path between the output 40 of the integrator block 16 and the input 38 of the summing block 14, and a capacitor C which is shunted to ground on the end of the resistor R which is nearest to the input 38. Therefore, for the embodiment of a first order low pass filter implemented as the delay element 70, $C(s)$ would be equal to $(1)/(1 - \tau_{comp}s)$, where $\tau_{comp}$ is equal to $(1)/(RC)$.

Inserting the transfer function of a first order low pass filter into the equation 9 enables equation 9 to be optimized to near unity by the determination of an optimal value for the time constant parameter $\tau_{comp}$. Distortion in the FM response of the PLL 100, therefore, may be reduced according to the value selected for $\tau_{comp}$. Once $\tau_{comp}$ is determined, typical values for $R$ and $C$ for use in a single pole low pass filter may be selected according to conventional techniques.

An optimal value for $\tau_{comp}$ may be conventionally determined by first computing an error function, $e(s,\tau_{comp})$, using the combined high pass and low pass responses of the PLL 100 as set forth in equation 9, where

$$e(s,\tau_{comp}) = (H_h(s) + H_l(s) - 1) * (H_h(s) + H_l(s) - 1)^*, \tag{12}$$

and where the raised asterisk * denotes complex conjugation. This error function $e(s,\tau_{comp})$ is the magnitude of the deviation of $x/m_1$ from unity. From this error function, a value for $\tau_{comp}$ may be determined that minimizes the maximum value of the expression of $e(s,\tau_{comp})$, where $s$ spans the whole frequency band of the modulating signal provided by the source 60.

Optimization of the equation 12 with respect to a value $\tau_{comp}$ which minimizes the maximum of error of the error function $(s,\tau_{comp})$ over $s$, however, is analytically intractable in its full generality. Therefore, an optimal value for $\tau_{comp}$ may be determined by assigning suitable values to the parameters in $e(s,\tau_{comp})$ and then computing values for $e(s,\tau_{comp})$ for different values of $\tau_{comp}$ and frequency $\omega$. For instance, the reference frequency signal which may suitably be applied at the input 30 of the phase detector 12 for obtaining broadband modulation using the PLL 100 is typically equal to 150 KHz. Note, as is well known, this reference frequency also corresponds to the step size or channel spacing, $f_\tau$, of the frequency synthesizer Therefore, $\tau$ may be suitably set equal to 3.33 micro ($\mu$) seconds (sec), which corresponds to half the time period of $f_\tau$. A suitable value for $F(s)$ may be assigned by setting $\tau_1$ equal to 5.168 $\mu$sec and $\tau_2$ equal to 6.8 $\mu$sec. In addition, $K_v$ may be suitably set equal to 1.257E8, $N$ may be set equal to 6100 and $K_\phi$ may be set equal to 3.14. For the above values, the error function $e(s,\tau_{comp})$ is optimally at a minimum for $\tau_{comp}$ equal to 3.224 $\mu$sec.

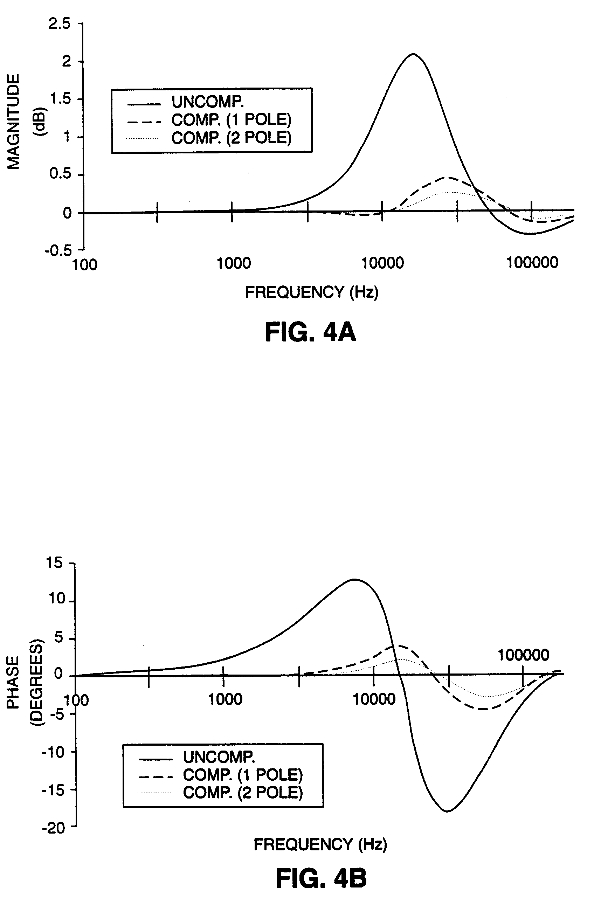

FIG. 4A shows plots of the uncompensated and delay compensated magnitude of the calculated FM response of the PLL 10 and the PLL 100, respectively, where a delay $\tau$ equal to 3.33 $\mu$sec is introduced by the divider 20. The modulating frequency is indicated in hertz on a logarithmic scale along the x-axis, and the relative magnitude of the FM response is plotted in dB along the y-axis.

Referring to FIG. 4A, one plot shows the calculated response for the PLL 10 without the addition of delay compensation. A second plot shows the calculated response for the PLL 100 where delay compensation is applied by setting $\tau_{comp}$ equal to 3.224 µsec in the expression $C(s) = 1/(1 + \tau_{comp}s)$ in equation 8 to represent the addition of the delay element 70 to the first modulating signal path as a first order low pass filter. A marked difference is evident, especially at the frequencies from 1000 through 100,000 Hz, in the distortion present between the uncompensated response of the PLL 10 and the compensated response of the PLL 100 where delay compensation is added in the PLL 100 by the addition of the delay element 70 to the first modulating signal path.

FIG. 4B shows plots of the uncompensated and the delay compensated phase of the calculated FM response of the PLL 10 and the PLL 100, respectfully, where a delay $\tau$ equal to 3.33 µsec is introduced by the divider 20. The modulating frequency is plotted on a logarithmic scale in hertz along the x-axis, and phase is plotted in degrees along the y-axis. One plot shows the calculated response for the PLL 10 without the addition of delay compensation. A second plot shows the calculated response for the PLL 100 where delay compensation is applied, as explained above, by the addition of the delay element 70 to the first modulating signal path as a first order low pass filter and setting $\tau_{comp}$ equal to 3.224 µsec in the representative expression for $C(s)$.

In a further embodiment, a multiple order or multiple pole low pass filter may be implemented as the delay element 70 to approximate the compensating delay $\tau_{comp}$ that may be introduced to compensate for distortion in the FM response which may be caused by the delay $\tau$ introduced to the feedback of the PLL 100 by the divider 20. For instance, a two pole low pass filter having a transfer function equal to $1 (1 \tau_{comp}s)^2$ may be implemented as the delay element 70. Inserting this expression for $C(s)$ in the equation 12, and then performing similar error function calculations as described above, a value $\tau_{comp}$ equal to 1.646 µsec would be calculated as optimally minimizing $e (s, \tau_{comp})$. For purposes of comparison with the calculated FM response of the PLL 100 including a single pole low pass filter embodiment of the delay element 70 and the calculated uncompensated FM response for the PLL 10, the calculated magnitude and phase FM responses for the $\tau_{comp}$ value calculated for the two pole low pass filter embodiment of the delay element 70 are also plotted in FIGS 4A and 4B.

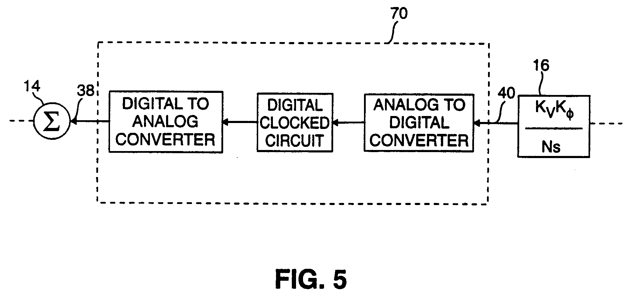

In a further aspect of this invention, a compensating delay may be introduced to the loop signal path of the PLL 100 to compensate for the spurious delay $\tau$ by implementing the delay element 70 digitally, as shown in FIG. 5. The delay element 70, implemented in digital form, may comprise an analog to digital converter (ADC) whose output is connected to an input of a digital clocked circuit (DCC), which has an output connected to an input of a digital to analog converter (DAC). The DAC further includes an output connected to the input 38 of the summing block 14, and the ADC further includes an input connected to the output 40 of the integrating block 16. For purposes of this invention, the DAC, ADC and DCC are standard digital components, and the DDC includes a memory.

In accordance with the inventive technique, the digitally implemented delay element 70 may be utilized for introducing a compensating delay $\tau_{comp}$ equal to $\tau$ in the feedback path of the PLL 100 as follows. The ADC digitizes the analog signal provided from the output 40 of the integrating block 16, and provides this digitized signal to the input of the DCC. The DCC writes the data representative of the digital signal to the memory. After a time interval $\tau_{comp}$ equal to $\tau$ has passed, the DDC retrieves the data representative of the digital signal from the memory and provides this data to the input of the DAC. The DAC then converts the digitized data back to analog signal form to reconstruct the analog signal originally provided to the delay element 70 from the integrating block 16. For purposes of this description, it is assumed that the total processing times in the DAC, DCC and ADC are included in $\tau_{comp}$.

Thus, the delay $\tau_{comp}$ associated in the transfer of the analog signal through the digitally implemented delay element 70 may be expressed as $e^{-j\omega\tau comp}$ The expression $C(s)$ in the equation 9 for describing the FM response of the PLL 100 would be set equal to $e^{-j\omega\tau comp}$. It is to be understood that the embodiments and variations shown and described above are illustrative of the principles of this invention only and that various modifications may be implemented by those skilled in the art without departing from the scope and spirit of the invention.

## Claims

1. A phase-locked loop having a compensating delay added to minimize distortions in the frequency modulation response, comprising

a first summing block having a first and second input port and an output port,

a second summing block having a first and second input port and an output port; a modulating source for providing a modulating signal to first and second modulating signal paths, wherein the first modulating signal path extends from the modulating source to the first input port of the first summing block and the second modulating signal path extends from the modulating source to the second input port of the second summing block;

an integrating block included in the first modulating signal path,

a loop filter having an input and an output port, wherein the input port is coupled to the output of the first summing block and the output port is coupled to the first input port of the second summing block;

a voltage controlled oscillator (VCO) having a tuning input port and an output port, wherein the tuning input port is coupled to the output of the second summing block;

a divider having an input and output port, wherein the input port is coupled to the output port of the VCO;

a phase detector comprising a reference port, an input port and an output port, wherein a reference signal is provided at the reference port and the input port of the phase detector is coupled to the output port of the divider, and,

a delay element included in the first modulating signal path, wherein said delay element introduces the compensating delay to the loop to compensate for a spurious delay which may be introduced by the divider and phase detector combination as a result of the frequency that the modulating signal is applied to the loop by the modulating source.

2. The phase-locked loop of claim 1, wherein the delay element is a low pass filter.

3. The phase-locked loop of claim 2, wherein the low pass filter is a single pole filter.

4. The phase-locked loop of claim 2, wherein the low pass filter is multiple pole filter.

5. The phase-locked loop of claim 1, wherein the delay element is a digitally implemented delay line.

6. A method for minimizing the distortion in the frequency response of a frequency modulated broadband phase-locked frequency synthesizer comprising a phase locked loop,

said phase locked loop comprising a first summing block having a first and second input port and an output port; a second summing block having a first and second input port and an output port; a modulating source for providing a modulating signal to first and second modulating signal paths, wherein the first modulating signal path extends from the modulating source to the first input port of the first summing block and the second modulating signal path extends from the modulating source to the second input port of the second summing block; an integrating block included in the first modulating signal path; a loop filter having an input and an output port, wherein the input port is coupled to the output of the first summing block, and the output port is coupled to the first input port of the second summing block; a voltage controlled oscillator (VCO) having a tuning input port and an output port, wherein the tuning input port is coupled to the output of the second summing block, a divider having an input and output port, wherein the input port is coupled to the output port of the VCO; a phase detector comprising a reference port, an input port and an output port, wherein a reference signal is provided at the reference port and the input port of the phase detector is coupled to the output port of the divider, and, a delay element included in the first modulating signal path,

the method for minimizing distortion in the frequency response comprising the steps of:

deriving an expression which represents the frequency response of the phase-locked loop;

calculating an optimal value for a compensating delay, which when introduced to the loop, compensates for any spurious delay which may be introduced by the phase detector and divider combination; and

selecting a delay element, based on the calculated compensating delay value, for inclusion in the first modulating signal path.

7. The method of claim 6, wherein the delay element is a low pass filter

8. The method of claim 7, wherein the low pass filter is single pole filter

9. The method of claim 7, wherein the low pass filter is multiple pole filter

10. The method of claim 6, wherein the delay element is a digitally implemented delay line.

8

**FIG. 1**

**PRIOR ART**

**FIG. 2**

**FIG. 3A**

**FIG. 3B**

**FIG. 4A**

**FIG. 4B**

**FIG. 5**

EP 0 718 963 A1

# DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-4 242 649 (WASHBURN CLYDE JR) 30 December 1980<br>* column 3, line 41 - column 5, line 17 *<br>* column 7, line 34 - column 8, line 55; figures 1,7,8 * | 1-3,6-8 | H03C3/09 |
| X | EP-A-0 044 154 (FLUKE MFG CO JOHN) 20 January 1982<br>* page 5, line 11 - page 15, line 16; figures 1,3 * | 1,2,4,6,7,9 | |
| A | EP-A-0 408 238 (PLESSEY OVERSEAS) 16 January 1991<br>* column 4, line 3 - column 5, line 5; figure 1 * | 1-10 | |
| A | US-A-4 447 792 (WYNN STEPHEN R) 8 May 1984<br>* column 2, line 11 - column 3, line 22; figure 1 * | 2-5,7-10 | |
| A | EP-A-0 401 947 (BOSCH GMBH ROBERT) 12 December 1990<br>* column 1, line 54 - column 3, line 9; figure 1 * | 1-10 | TECHNICAL FIELDS SEARCHED (Int.Cl.6)<br><br>H03C<br>H04L<br>H03L |

The present search report has been drawn up for all claims

| Place of search | Date of completion of the search | Examiner |
|---|---|---|
| MUNICH | 4 April 1996 | Zwicker, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document